(19)

Europäisches
Patentamt
European
Patent Office
Office européen
des brevets

(11)  **EP 4 443 684 A1**

(12)  **EUROPEAN PATENT APPLICATION**

(43) Date of publication:
**09.10.2024  Bulletin 2024/41**

(21) Application number: **24167093.4**

(22) Date of filing: **27.03.2024**

(51) International Patent Classification (IPC):
*H02J 1/02* (2006.01)    *H02J 13/00* (2006.01)
*H04B 3/54* (2006.01)

(52) Cooperative Patent Classification (CPC):
**H02J 1/02; H02J 13/00022; H04B 3/548**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **05.04.2023   US 202363457191 P
14.03.2024   US 202418605100**

(71) Applicant: **Panduit Corp.
Tinley Park, IL 60487 (US)**

(72) Inventors:
• **Balid, Walid
  Orland Park (US)**
• **Bolouri-Saransar, Masud
  Orland Park (US)**

(74) Representative: **Roberts, Gwilym Vaughan et al
Kilburn & Strode LLP
Lacon London
84 Theobalds Road
London WC1X 8NL (GB)**

(54)  **FAULT DETECTION AND MANAGEMENT SCHEME FOR SAFE HV-DC POWER DISTRIBUTION SYSTEM**

(57)    A reliable fault detection and management system is described for providing safe high-voltage DC power delivery and distribution. The high voltage power delivery system provides a safer, more reliable, and easy-to-install power delivery system, while also providing for an RF communication link over a high-voltage single pair conductor cable.

**EP 4 443 684 A1**

**Description**

**CROSS-REFERENCE TO RELATED APPLICATION(S)**

This application claims benefit to U.S. Provisional Patent Application No. 63/457,191, filed on April 5, 2023, the entirety of which is hereby incorporated by reference herein.

**BACKGROUND**

Reliable and safe power distribution systems are the backbone to offering infrastructure solutions that people rely on in their day-to-day lives. In modern applications, providing reliable and safe power over longer distances may be made possible by utilizing high voltage power according to the Class 4 power systems defined by the National Electrical Code (NEC). Class 4 power systems are defined as power systems that offer significant power over long distances, while also abiding by safety requirements.

However, even within the Class 4 power system category, there are different solutions available. Therefore, the current disclosure describes a Class 4 power system that offers safer and more reliable power compared to other known solutions.

**SUMMARY**

This section provides a general summary of the disclosure and is not a comprehensive disclosure of its full scope or all of its features.

According to an embodiment, a DC power transmitter for use in a class 4 power system is provided, the DC power transmitter comprising: a high voltage power supply; a current sensing circuit configured to monitor a current on a bus coupled to the high voltage power supply; a safety controller configured to monitor an output of the current sensing circuit to control a switch for regulating a power output of the high voltage power supply; a communication interface for receiving a communication signal from the safety controller; a band pass filter configured to receive the communication signal from the communication interface and transmit the communication signal over a transmission line; and a band stop filter configured to receive the power output from the high voltage power supply and transmit the power output over the transmission line.

**DESCRIPTION OF THE FIGURES**

FIG. 1 illustrates components of an exemplary safe DC power delivery system, according to an embodiment.

FIG. 2 illustrates an exemplary view showing how the components of the safe DC power delivery system shown in FIG. 1 can be configured in a point-to-point topology to provide combined power, according to an embodiment.

FIG. 3 illustrates an exemplary view showing how the components of the safe DC power delivery system shown in FIG. 1 can be configured in a daisy-chain topology, according to an embodiment.

FIG. 4 illustrates an exemplary system architecture for a single channel safe DC power delivery system, according to an embodiment.

FIG. 5 illustrates an exemplary fault detection safety system included in a safe DC power delivery system, according to an embodiment.

FIG. 6 illustrates an alternative exemplary fault detection safety system included in a safe DC power delivery system, according to an embodiment.

FIG. 7 illustrates an alternative exemplary fault detection safety system included in a safe DC power delivery system, according to an embodiment.

FIG. 8 illustrates an alternative exemplary fault detection safety system included in a safe DC power delivery system, according to an embodiment.

FIG. 9 illustrates an alternative exemplary multi-drop implementation of a safe DC power delivery system, according to an embodiment.

FIG. 10 illustrates an exemplary depiction of a communication signal that is configured to provide asynchronized slotted communication in the multi-drop implementation of the safe DC power delivery system shown in FIG. 9, according to an embodiment.

FIG. 11 illustrates an exemplary depiction of a communication signal that is configured to provide synchronized slotted communication in the multi-drop implementation of the safe DC power delivery system shown in FIG. 9, according to an embodiment.

FIG. 12 illustrates an exemplary system architecture for an RF communication subsystem included in a safe DC power delivery system, according to an embodiment.

FIG. 13 illustrates an exemplary graph plotting duration of current against an amount of current for detecting a fault current limit in a safe DC power delivery system, according to an embodiment.

FIG. 14 illustrates an exemplary system architecture of a safe DC power delivery system configured to implement the fault current limit detection shown in FIG. 13, according to an embodiment.

## DETAILED DESCRIPTION

The methods, devices, systems, and other features discussed below may be embodied in a number of different forms. Not all of the depicted components may be required, however, and some implementations may include additional, different, or fewer components from those expressly described in this disclosure. Variations in the arrangement and type of the components may be made without departing from the spirit or scope of the claims as set forth herein. Further, variations in the processes described, including the addition, deletion, or rearranging and order of logical operations, may be made without departing from the spirit or scope of the claims as set forth herein.

Class 4 power systems are able to change how clients remotely power their devices to utilize better safety levels and power efficiency. Class 4 power systems are not power limited as are the lower powered classes and have a maximum voltage of 450V while also being designed with safety at their forefront. The safety circuit(s) implemented on the power source/transmitter and/or receiver control power delivery in a Class 4 power system, monitors for faults and limits energy and power available during a fault event.

Underwriters Laboratories (UL) recently published UL 1400-1 and UL 1400-2, where both documents have been submitted through the ANSI process to become a standard. UL 1400-1 defines the requirements for fault-managed power systems (FMPS), while UL 1400-2 describes the safety considerations and criteria for evaluating Class 4 circuit cabling.

FMPS is associated with a NFPA/NEC designation of Class 4. This is a fault energy-limited power source that protects against shock or fire hazards in a much different way. It continuously monitors the wiring for faults, and if a fault is detected (e.g., someone accidentally touches exposed wires during operation), it will immediately and automatically isolate the power by limiting the fault energy to a safe level.

FMPS is not power limited and can safely deliver hundreds of Watts of power, thus allowing the industry to support power at higher levels and across longer distances with cables that were previously limited to power levels of 100W (e.g., Class 2) or distances of 100 meter (e.g., distance limitation for Power over Ethernet (PoE)). For example, using a pair of 18 AWG wires, an FMPS system may transport 2kW for 400m or 400W for 2000m, both at an efficiency better than 70%. An FMPS is designed to be touch safe. An FMPS continuously scans the connecting wiring to detect the presence of a fault. The circuitry will open if a fault is present well within the safety guidelines to prevent ventricular fibrillation events.

FMPS allows centralized remote power management and distribution, power metering, and power backup without the need for cable conduit. Compared to Class 2 DC power (e.g., ESLV Power Supplies, PoE, etc.), DC power in Class 4 (up to 450V DC), can deliver more power over much longer distance using a thinner copper conductor.

This disclosure describes a novel fault detection and management solution that may take on the embodiment of an enhanced FMPS that is configured to meet the criteria described herein for providing highly reliable, safe, high-voltage DC power delivery and distribution. The described solution demonstrates various techniques and methods used to integrate a functional safety rated RF communication link over a high-voltage single pair conductor cable. The implementation of these techniques demonstrated herein are intended to meet the requirements for Class 4 power system as defined by the NEC, and further designed to comply with UL Standard 1400-1 and/or 1400-2 for a safer, more reliable, and easy-to-install power delivery system that provides significant power over long distances, while also providing substantial time and cost savings.

Unlike pulse power or pulse current systems for providing Class 4 power that rely on chopping (i.e., pulsing) up the direct current into ON/OFF intervals and test for a fault condition in each interval before another pulse can be transmitted, the present solution controls the direct current delivery from the source (transmitter), over a standard multi-conductor copper cable, to the load (receiver) without chopping the high voltage. The receiver converts the high voltage direct current into a voltage applicable to the clients (e.g., +/- 57 VDC), which can be used to power multiple end devices. For purposes of this disclosure, this solution will be referred to as Safe DC Power (SDCP), and the SDCP delivery system.

The SDCP delivery system implements redundancy for fault detection circuits that check the transmission line for different fault incidents, including, for example: 1) Human touching cable; 2) a short circuited cable; 3) a cable disconnect; 4) an undervoltage case; 5) an overvoltage case; or 6) a load disconnect. If a fault occurs, the transmitter, in collaboration with the receiver(s), detects the change in the line current and within a very short time disconnects the transmitter's high voltage power source. A Safety Extra Low Voltage (SELV) value (or as defined in UL1400-1 a value less than the "let-go" limit) may be referenced to verify the transmission line is safe before enabling the high voltage power again following a safety disconnect action. This makes the copper conductor safe to touch, which simplifies installation (e.g., no cable conduit is needed, doesn't require certified electrician, etc.), and reduces deployment time and cost. The SDCP delivery system employs the solutions described herein to provide higher power efficiency and reduce the switching stress and noise compared to pulsing solutions that depend on chopping up high voltage current.

In the SDCP delivery system, a single or multi-frequency RF communication signal may be super imposed onto the same transmission line to provide the capability for enabling system safety, management, control, and data reporting for a scalable and manageable power distribution system.

System Architecture

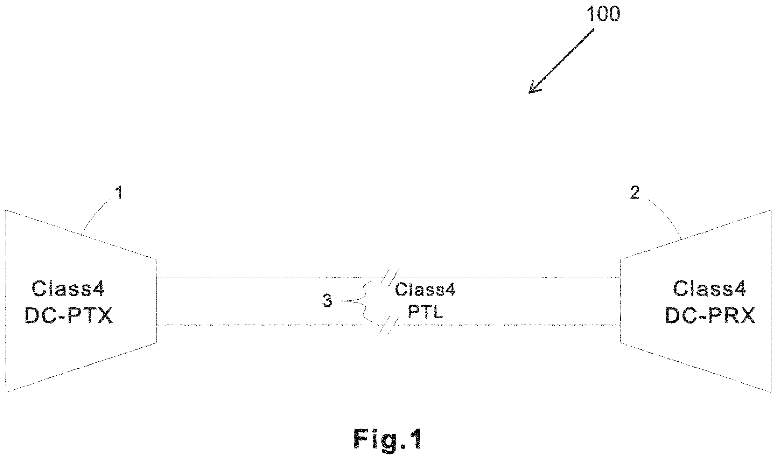

FIG. 1 illustrates an exemplary SDCP system 100, which is composed of three main elements: a DC Power Transmitter (DC-PTX) 1 (i.e., the transmitter side 1), a DC Power Receiver (DC-PRX) 2 (i.e., the receiver side 2), and a power transmission line (PTL) 3. The SDCP system 100 shown in FIG. 1 is an example of a single enclosed point-to-point SDCP system. However, the SDCP system 100 may be expanded to connect with more enclosed systems under a centralized management point. For example, one SDCP system may include up to 48 DC-PRX channels that connect to DC-PRX channels over single pair PTLs in a point-to-point fashion.

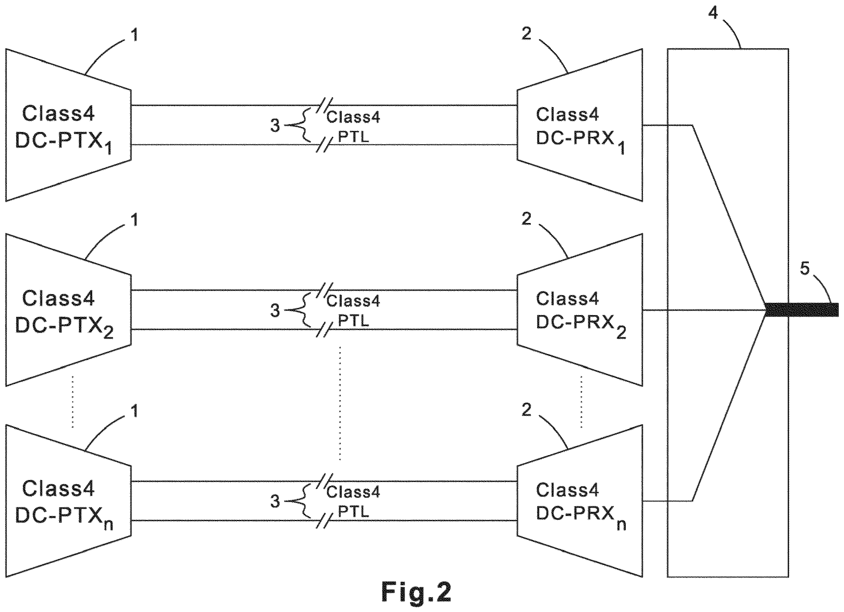

The SDCP system 100 may also support combining several DC-PRX channels to support a higher output power as illustrated in FIG. 2. An integrated power combiner circuit 4 may include n number of controlled output switches, n number of reverse current/polarity blocking/protection controllers, n number of load sharing controllers, and a employ sophisticated load startup algorithm, where n is an integer number. As shown in FIG. 2, a load 5 may then be connected to the output of the integrated power combiner circuit 4 to receive the combined power.

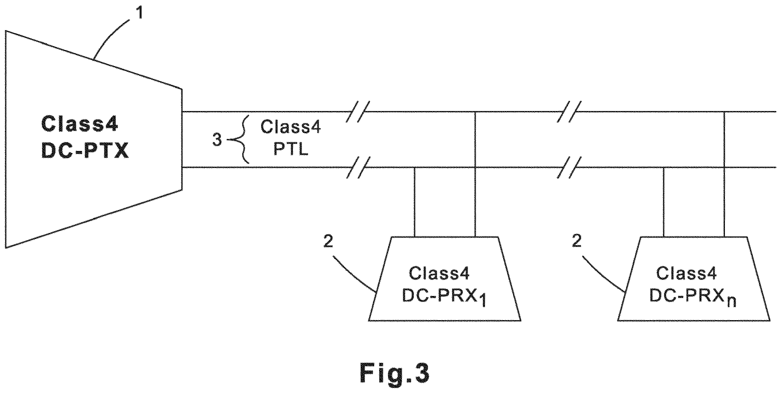

The interconnection between DC-PTX 1 and DC-PRX 2 may not be limited to point-to-point circuit coupling topologies but may also be coupled according to a "bus or multi-drop" topology as depicted in FIG. 3. When coupling the DC-PTX 1 and DC-PRX 2 in such daisy-chain circuit coupling topologies as shown in FIG. 3, a single DC-PTX 1 may drive n DC-PRX 2 channels. Each DC-PRX 2 channel may be addressed with a unique address that is assigned at the startup of the SDCP system 100 over an RF communication link.

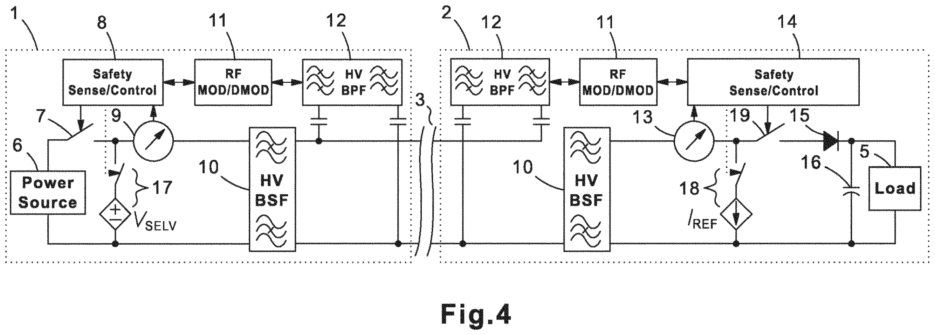

FIG. 4 shows a more detailed exemplary system architecture of a single channel in the SDCP system 100. This system architecture includes the sub-systems that super impose the high-voltage power and RF communication data over the PTL 3.

In the detailed system architecture shown in FIG. 4, components that are part of the DC-PTX 1 are shown within the corresponding dotted lines, and components that are part of the DC-PRX 2 are shown within the corresponding dotted lines. The PTL 3 is still shown to be the connection for transmitting signals between the DC-PTX 1 and the DC-PRX 2.

Included in the DC-PTX 1 is a high-voltage power supply (PSU) 6 with a programmable current limiter. The input power to the PSU 6 may be AC or DC power. The output of the PSU 6 is up to $\pm225V$ DC and current limited, where the output of the PSU 6 is directly controlled by a redundant CPE 8 via one or more high power switch(s) 7.

The output from the switch 7 is fed into a highly accurate current sensing circuit 9 that continually monitors the line current in the DC-PTX 1. The current sensing circuit 9 may be utilized to monitor the current on the high-side, low-side, or both sides of the bus. The data output from the current sensing circuit 9 is analyzed in real-time by the CPE 8.

The power output of the current sensing circuit 9 is fed into a high-voltage, high-power, very narrow-band, resonance band-stop filter 10. The band-stop filter 10 may be constructed from high-power and high voltage resonance inductors and capacitors to provide very high characteristic impedance (notch) at the RF communication carrier frequency and very low impedance otherwise. Without this band-stop filter 10, the RF signal would be shunted by the system bulk capacitance.

The output of band-stop filter 10 connects directly to the PTL 3. The RF communication signal is a differential signal that is super imposed onto the same PTL 3 via a differential, high-voltage, narrow-band, resonance band-pass filter 12. The band-pass filter 12 may be constructed from high voltage resonance inductors and X1Y1 capacitors that are used to provide 3KV reinforced isolation barrier between the primary circuit (HV) and secondary circuit (LV) and to block the DC component such that only the low-voltage, high frequency components in the filter band can be seen by the RF front-end.

The communication signal is encoded or decoded by the CPE 8 and modulated or demodulated via a single-carrier or multiple-carrier frequency using an RF modulator/demodulator 11. The communication signal provides a mean of system safety, management, control, and data reporting for a scalable and manageable power distribution system. A more detailed system architecture for the RF modulator/demodulator 11 is described later in this disclosure.

The DC-PRX 2 includes many of the same elements as included in the DC-PTX 1, including the band-stop filter 10, the RF modulator/demodulator 11, and the band-pass filter 12. A current sensing circuit 13 in the DC-PRX 2 is similar to the current sensing circuit 9 in the DC-PTX 1, however the current sensing circuit 13 is tuned to the *load* maximum current rather than the *source* maximum current. The current sensing circuit 13 may also be utilized to monitor the current on the high-side, low-side, or both sides of the bus.

A computation processing element (CPE) 14 analyzes the real-time data received from the current sensing circuit 13, implements the communication signal encoding and decoding for the RF modulator/demodulator 11, and controls the power conversion of the DC-PRX 2. The CPE 14 is configured for safety sensing and control, as described in more detail herein.

The circuit component 15 (e.g., a diode) is used to block the reverse current released from the DC bus bulk capacitor 16. The circuit component 17 (e.g., including the SELV) is used to put a safety extra low voltage (SELV) on the PTL 3 to verify the line is safe before enabling the high voltage power again. The circuit component 18 is only active when the circuit component 17 (e.g., including the SELV) is active and used as a reference load to verify the system fault detection circuitries. The circuit component 17 (e.g., including the SELV) together with circuit component 18 provide a test the tester function, system verification function, and load presence function for the SDCP system 100. The circuit component 18 includes a reference load component.

A switch 19 is used to disconnect the load for system calibration/verification during initialization, as well as for system validation/Test-the-Tester function during normal operation. The circuit component 18 together with switch 19 provide a system calibration/verification function during initialization, as well as during normal operation, of the SDCP system 100.

Fault Detection

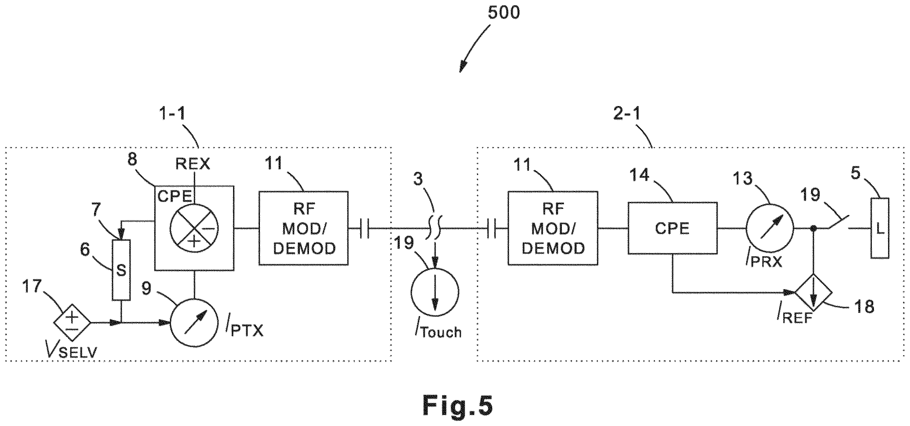

FIG. 5 shows a high-level architecture view of an exemplary SDCP system 500 that includes a transmitter side 1-1 and a receiver side 2-1, and showing components involved in the safety fault detection function of the SDCP system 500. The transmitter side 1-1 includes the components for implementing the primary safety related functions. These functions employ fault detection circuits that check the PTL 3 for different fault incidents, including, for example: 1) a Human touching cable; 2) a short-circuited cable; 3) a cable/load disconnect; 4) an undervoltage case; 5) an overvoltage case; 6) an overloading case; or 7) an arc event. Under a fault condition such as a cable touch, the transmitter side 1-1 in collaboration with the receiver side 2-1 detects the change in the PTL 3 current and instantly disconnects the high voltage power source 6.

The transmitter side 1-1 employs a safety extra low voltage (SELV) source 17, where the SELV source 17 is enabled during a system initialization and during a fault recovery process of the SDCP system 500 to verify the presence of receiver side 2-1, establish the RF communication link, and verify the safety condition of PTL 3 before enabling the high-voltage power source 6. The safety-level control that is used to enable/disable the high voltage power supply 6 through a redundant power switch 7. The safety signals controlling both the current sensing circuit 9 and the SELV source 17 are handled by a computation processing element (CPE) 8. The CPE 8 may be based-on discrete hardware, functional-safety certified processors or programmable logic circuits. The CPE 14 is configured for safety sensing and control, as described in more detail herein.

Once a communication link is established and receiver side 2-1 verifies its presence and integrity, the transmitter side 1-1 commands the receiver side 2-1 to start a condition verification process on the PTL 3. This process includes introducing a calibrated refer circuit component 18 (e.g., reference load), which sinks current that is equal to the system's minimum current sensing resolution. The current sensing circuit 9 monitors the feeding current though the PTL 3 and the current sensing circuit 13 monitors the sink current by the circuit component 18 (e.g., reference load). The data output of current sensing circuit 9 and the current sensing circuit 13 is analyzed in real-time by the CPE 8 and the CPE 14, in their respective transmitter side 1-1 and receiver side 2-1. The switch 19 is disconnected during the verification stage.

The system verification process continues over a pre-defined period. During which time, the data analyzed real-time is being encoded/decoded by the CPE 8 and the CPE 14, and also modulated/demodulated by the RF modulator/demodulator 11 in both their respective transmitter side 1-1 and receiver side 2-1. The CPE 8 implements a further step by analyzing the current sensing data in addition to other system metrics from both sides (i.e., transmitter side 1-1 and receiver side 2-1) to verify that standards for the system integrity, validity, and safety are all met.

Once verified, The CPE 8 commands the CPE 14 to disable the circuit component 18 (e.g., reference load) and wait until disabled by an acknowledgement over the communication link and monitoring the feed current received via the current sensing circuit 9. After that, the SELV 17 is disabled, and the high voltage power supply 6 is enabled. The SDCP system 500 is switched now to the normal operation mode where the receiver side 2-1 can introduce the load 5 to be powered by closing the switch 19.

In the normal operation mode, the SDCP system 500 at both ends is monitored in real time for any fault condition where the current sensing circuit 9 monitors the feeding current though PLT 3, and the current sensing circuit 13 monitors the sink current by the load 5. The data output of the current sensing circuit 9 and the current sensing circuit 13 is analyzed in real-time by CPE 8 and CPE 14, respectively. The CPE 14 encodes the analyzed data and the RF modulator/demodulator 11 then modulates the data to be communicated to the transmitter side 1-1 in a dynamically allocated/assigned communication slot. The RF modulator/demodulator 11 on the transmitter side 1-1 side modulates the data being sent to the receiver side 2-1 and demodulates the data received from the receiver side 2-1. The CPE 8 processes the received monitoring data and compares it to the local monitoring data. If the real-time current provided by the high voltage power supply 6 is equal to sink current by the load 5, the normal operation will continue. Otherwise, the CPE 8 shuts off the high voltage power supply 6 and goes back into system verification mode. Any of the seven fault incidents listed above may also cause the system to backoff power and switch into the system verification mode.

In the normal operation mode, the transmitter side 1-1 and the receiver side 2-1 collaboratively preform a Test-the-Tester (TtT) procedure without switching back to the verification mode. The TtT procedure adds another layer of safety verification by executing an on-the-fly system diagnostic procedure. The procedure utilizes a dynamically assigned communication slot in each communication cycle to introduce the calibrated reference load in the circuit component 18 (e.g., reference load) for a very short time. The circuit component 18 (e.g., reference load) is introduced with and/or without disconnecting the switch 19. There are three exemplary scenarios:

1) The circuit component 18 (e.g., reference load) is not introduced, and the switch 19 is connected: the current sensing circuit 9 and the current sensing circuit 13 should both sense the current of the load 5 only,

2) The circuit component 18 (e.g., reference load) introduced, and the switch 19 is connected: the current sensing circuit 9 and the current sensing circuit 13 should both sense the current sum of the load 5 and the circuit component 18 (e.g., reference load), or

3) The circuit component 18 (e.g., reference load) is introduced + the switch 19 is disconnected: the current sensing circuit 9 and the current sensing circuit 13 should only sense the circuit component 18 (e.g., reference load).

The receiver side 2-1 will communicate the data to the transmitter side 1-1 in that slot for validation. More details about communication slots and cycles are covered in the Communication Link Session below.

Expanded Fault Detection with Redundant Current Sensing

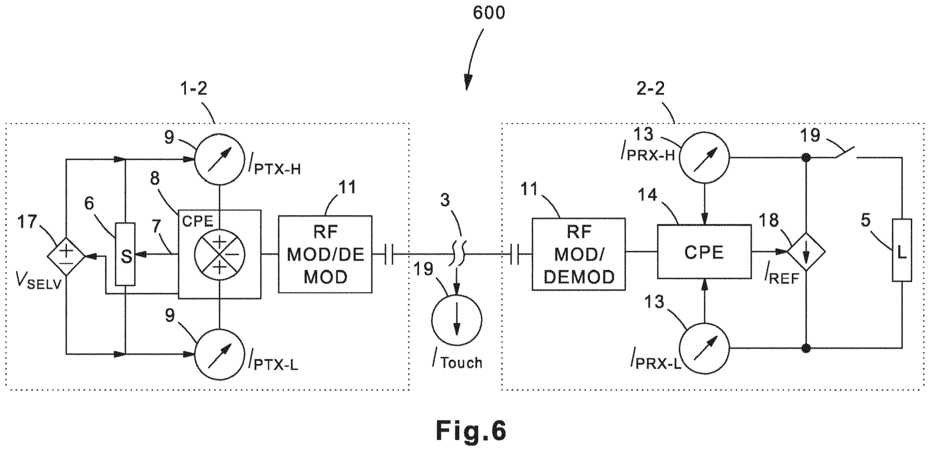

FIG. 6 shows an exemplary system architecture for a SDCP system 600 that expands on the safety systems shown in FIG. 5 by adding continuous current monitoring on both sides (e.g., transmitter and receiver sides) of the line. The SDCP system 600 includes a transmitter side 1-2 and a receiver side 2-2.

This solution works in a similar fashion to that in FIG. 5 except that the current is being monitored on the high-side and low-side of the bus at both sides of the system at the transmitter side 1-2 (redundant current monitoring circuits 9) and the receiver side 2-2 (redundant current monitoring circuits 13).

The advantage of this extended concept for the SDCP system 600 is that the real-time current data on the high- and low-side is analyzed to detect any leakage current in the transmitter side 1-2 and/or the receiver side 2-2. In addition, this concept adds a natural redundancy to the current monitoring circuits 9 and 13 such that the CPE 8 compares the high-side and low-side current data received from the receiver side 2-2 to the data in the transmitter side 1-2. Both sides must match to determine the SDCP system 600 is safe.

Expanded Fault Detection with System Redundancy

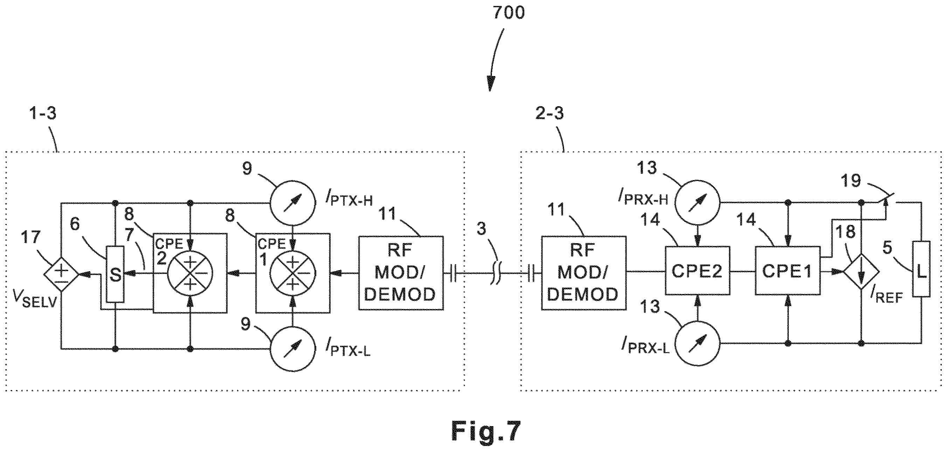

The concepts illustrated in FIG. 5 and FIG. 6 implement 1OO1 (1-out-of-1) architecture. To achieve a better Fault-in-Time rate (FIT) and/or higher Safety Integrity Level (SIL) rate, a redundancy can be introduced to the SDCP system 700 as shown in FIG. 7. For example, SIL3 can be achieved with two SIL-rated CPEs in 1OO2 (1-out-of-2) architecture.

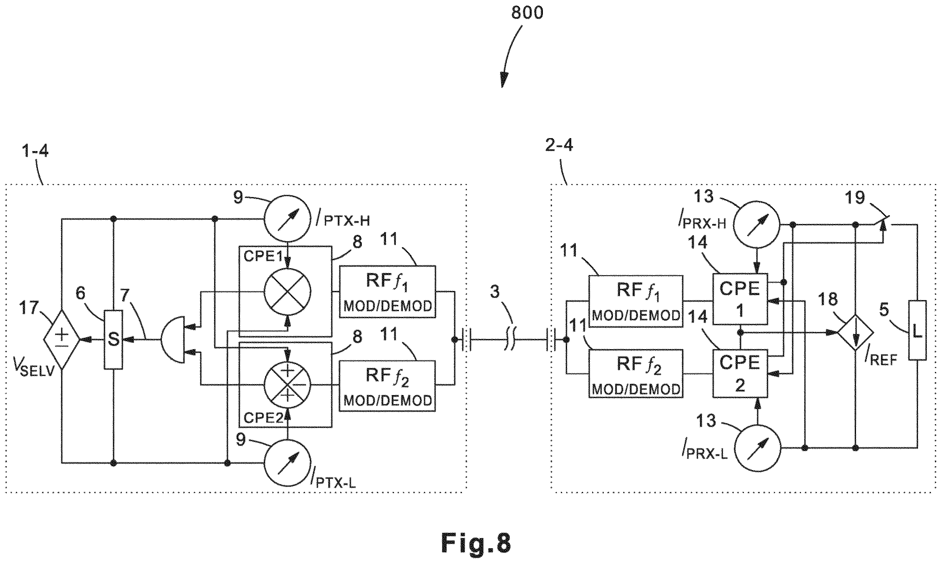

To achieve H1, the system architecture can be implemented in individual scheme or collaborative scheme. FIG. 7 illustrates 1OO2 collaborative scheme for redundancy in the SDCP system 700. FIG. 8 illustrates 1OO2 individual scheme for redundancy in the SDCP system 800.

The 1OO2 collaborative scheme in FIG. 7 employs two CPEs 8 on the transmitter side 1-3 and two CPEs 14 on the receiver side 2-3. Each of the CPEs 8, 14 are interfaced to a precision current sensing circuit 9, 13 on the high- and low-side of the DC bus, respectively.

In the receiver side 2-3, the real-time current sensing data stream on the high- and low-side of the bus is first analyzed by both CPE1 14 and then CPE2 14. Then the outcome is shared between the two CPEs 14 for a collaborative data validation. The outcome from both is assigned to CPE2 14 to encode and communicate to the transmitter side 1-3.

The transmitter side 1-3 on the other hand, executes the same procedure, except that both CPE1 8 and CPE2 8 receive the data analyzed by CPE1 14 and CPE2 14 on the receiver side 2-3, and both CPEs 8 execute the comparison and collaboratively make a decision. The decision outcome is then assigned to CPE2 8 to execute.

The 1OO2 individual scheme in FIG. 8 employs two independent channels. Each channel does an individual analysis and decision. The outcome of each is then mapped into a hardware decision-making logic that keeps the high voltage power supply 6 enabled IF and ONLY IF both individual sub-systems agree that the SDCP system 800 is in working reliably and in a safe condition. Otherwise, the high voltage power supply 6 will be disabled instantly, and the SDCP system 800 will fall back to the verification mode.

The 1002 individual scheme used in the SDCP system 800 also utilizes two independent communication channels on the same pair of wires. Given that both communication circuit channels utilize the same transmission line, the data of each channel should be kept independent and separate. To do so, the two channels may employ one of the following implementations:

Single carrier frequency and two different digital modulation schemes;
Two different carrier frequencies-$f_1$ / $f_2$-and one digital modulation scheme; or
Two different carrier frequencies- $f_1$ / $f_2$-and two different digital modulation schemes.

More details about the above implementations are discussed in the Communication Link section below.

Expanded Design with Multi-Drop Bus and Slotted Communication Link

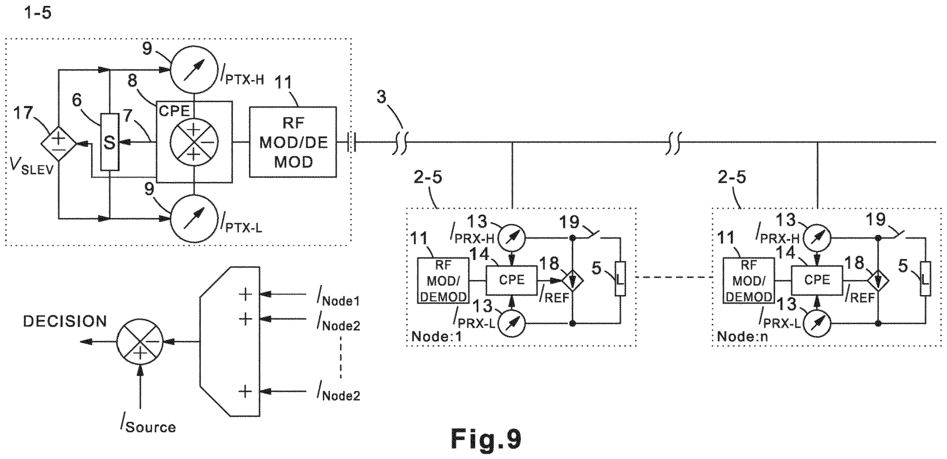

FIG. 9 illustrates a multi-drop system implementation of a SDCP system 900 that builds upon the concepts demonstrated in previously described embodiments. The multi-drop SDCP system 900 implements single-master, multi-slave configuration topology. The communication link employs slotted communication protocol where each slave in the receiver side 2-5 utilizes a pre-defined or assigned communication slot within a dynamic communication window to communicate its data.

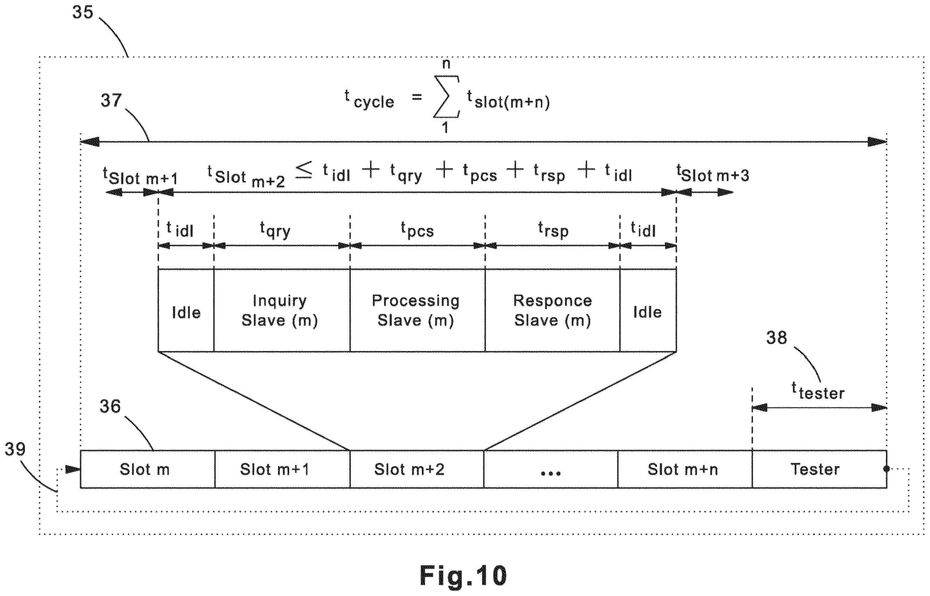

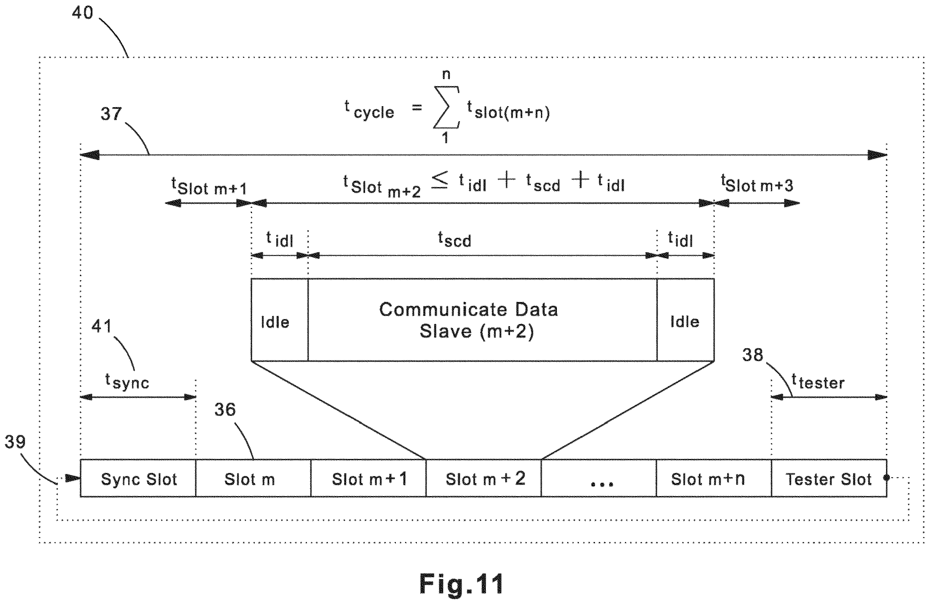

FIGs. 10 and 11 show exemplary representations of communication signals 35, 40 that utilize the asynchronized slotted communication feature and the synchronized slotted communication feature, respectively. The communication slot 36 in the communication signals 35, 40 is assigned by the master in an Asynchronized Communication Mode or pre-defined in a Synchronized Communication Mode. The communication window 37, however, is dynamically adjusted in both modes for maximum utilization of the communication link bandwidth, which depends on the number of nodes connected to the bus.

The communication signal 35 shown in FIG. 10 is being utilized in the asynchronized communication mode, according to an embodiment. The Asynchronized Communication Mode is defined as: The Master in the transmitter side 1-5 assigns a communication slot 36 for a specific slave node in the receiver side 2-5. Each node has a unique ID. The slave node communicates data upon receiving an inquiry addressing the node from the master.

FIG. 10 illustrates an exemplary representation of the communication signal 35 utilizing asynchronized slotted communication in multi-drop system architecture. An "Idle Time" ($t_{idl}$) is employed at the beginning and at the end of the window to account for propagation delays, tolerance factors, and reduce the chance for any communication collision. The "Inquiry Slave" ($t_{qry}$) is the commands sent by the master to address a specific node and request data. The "Processing Slave" ($t_{pcs}$) is the time required by the salve node to process the data requested by the master. The "Processing Slave" ($t_{rsp}$) is the time needed for the master to receive and process the received data from the addressed node. The "Slot Time" ($t_{slot}$) is the total time to execute the slot processes.

The number of slots depends on the number of nodes. The time of each slot is dynamically adjusted based on the number of nodes. The total time required for all slots ($t_{cycle}$) is the communication link window time 37 that should not exceed the "Duration of Current" for the "Fault Current Limit Curve" defined for safe delivery of current value over current duration.

The last slot 38 is allocated for a TtT procedure that is executed at the end of every cycle, which means the SDCP system 900 is being self-validated every cycle within the time defined by "Fault Current Limit Curve". The cycle is sequential and repeats itself in a loop 39.

Once the cycle is complete, the master transmitter side 1-5 accumulates the received data and compares it to the reference source data (current). The master disconnects the high voltage power source 6 and switches into system verification mode if the sinking current is not matched to the sourcing current.

The Synchronized Communication Mode is defined as: The Master sends a broadcast signal in the first slot of each cycle to address all nodes to sync to it. Every node communicates its data in a pre-defined slot.

FIG. 11 illustrates an exemplary representation of the communication signal 40 utilizing synchronized slotted communication in a multi-drop system architecture. All nodes are synchronized to a sync signal that is generated by the master over the communication link. The sync signal is allocated in the first slot 41 ($t_{sync}$) of the communication window 37, which means all nodes are tightly synchronized to the same clock signal in every cycle. The "Idle Time" ($t_{idl}$) is employed at the beginning and at the end of the window to account for propagation delays, tolerance factors, and reduce the chance for any communication collision. The "Slave Communicates Data" ($t_{scd}$) is the node utilizing the communication link to send data. No inquiry from the master is needed since all nodes are synced and the communication slot are pre-allocated. The last slot 38 ($t_{tester}$) is allocated for a TtT procedure. The cycle is sequential and repeats itself in a loop 39.

The Synchronized Communication Mode is more efficient in terms of bandwidth as each node independently sends its data to the master without adding an inquiry command. All the nodes are also synced in the system initialization stage. Any system configuration commands over the communication link must be executed in the initialization stage when the SLEV source is enabled. User's data, maintenance data, system information, etc. is also executed in the normal operation mode, however, the highest priority is assigned to communicate the safety data.

Communication Link

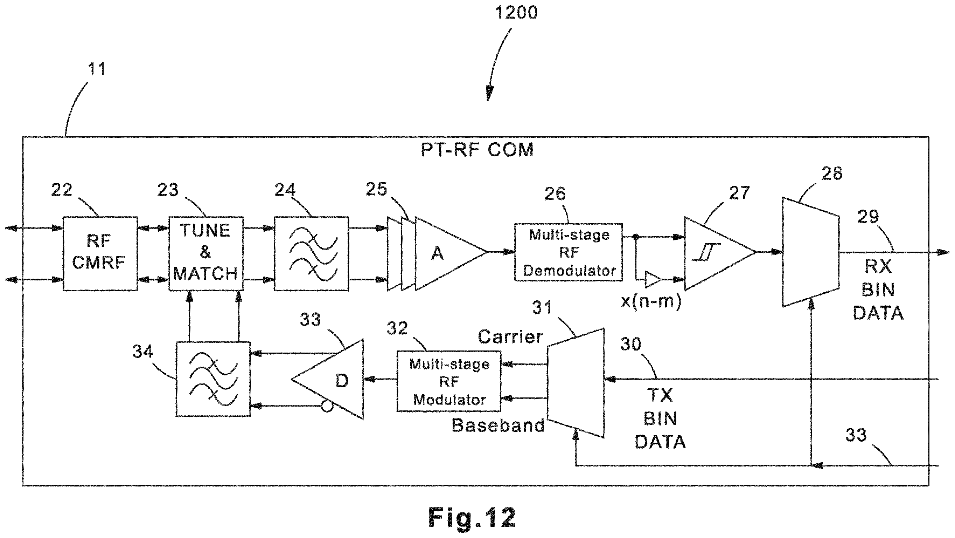

FIG. 12 illustrates an exemplary system architecture for an RF Communication subsystem 1200 that may be included in any one or more of the SDCP systems described herein. The communication signal provides a means of providing system safety, management, control, and data reporting for a scalable and manageable power distribution system. The RF communication signal is a differential signal that is super imposed onto the same PTL via a differential, high-voltage, narrow-band, resonance band-pass filter 12. The band-pass filter 12 is constructed of high voltage resonance inductors and X1Y1 capacitors that are used to provide 3KV reinformed isolation barrier between the primary and secondary circuit and to block the DC component such that only the low-voltage, high frequency components in the filter band can be seen by the RF front-end 11.

FIG. 12 illustrates the RF Communication front-end 11 sub system. The differential RF signal connects with the RF front-end 11 at a current compensated common-mode (CM) rejection filter 22 that blocks any CM interference by providing $10K\Omega \sim 15K\Omega$ CM impedance and close to zero differential impedance over the RF communication band.

The RF front-end 11 also includes a matching and tuning network 23 that can be tuned to match the transmission line impedance depending on the characteristic impedance of the cable and the number of multi-drop points connected on the bus in a daisy-chain use case.

The RF front-end 11 also includes a high order selective active passband filter 24, a. multi-stage, fully differential input, low-noise amplifier 25, and a multi-stage RF demodulator 26. The demodulated signal is fed into a self-biased discriminator 27 that has a time varying delay to provide dynamic reference. The digitized signal is fed into a synchronous decoder 28 that employs bit-banging algorithm to decode the data. The decoded data is analyzed and stored afterwards in a data storage unit 29 (e.g., a memory).

For data transmission, the binary data is fed from a data storage unit 30 (e.g., may be same as data storage unit 29) to the CPE, which encodes the binary data 31 and generates the corresponding baseband frequency and carrier frequency. The RF front-end 11 also includes a multi-stage RF modulator 32 that modulates the encoded data.

The modulated data from the multi-stage RF modulator 32 is fed into a uni-directional, differential digital line driver 33, and then to a differential, high-Q, resonance band-pass filter 34. The output from the band-pass filter 34 is a balanced, modulated RF signal.

The RF communication signal encoding/decoding and modulation/demodulation is done on multi-stages for the redundancy and reliability reasons described in "Detection with System Redundancy" section. A single-carrier or multi-carrier frequency is used by the RF demodulator 26 and/or the RF modulator 32. Two different implementations are considered:

    1. Single carrier frequency and two different digital modulation schemes.
    2. Two different carrier frequencies- $f_1$ / $f_2$-and two different digital modulation schemes.

Single Carrier Frequency and Multi-Modulation Schemes

This implementation relies on modulating two different baseband signals, each encodes data from different CPE, using a single carrier frequency. This is done by modulating the carrier in the 1st stage by FSK (Frequency Shift Keying) or PSK (Phase Shift Keying) modulation scheme. In the 2nd stage, an ASK (Amplitude Shift Keying) modulation scheme is carried out on the modulated version of the carrier signal of the 1 st stage. The result is that the first message data is frequency or phase modulated and the second message data is amplitude modulated. To extract the two messages at the receiver side, an ASK and FSK demodulators are used to extract the messages simultaneously.

This implementation provides two independent data channels over a single carrier frequency, which is ideal for the 1002 Collaborative Scheme.

Multi-Carrier and Multi-Modulation Scheme

This implementation relies on modulating two different baseband signals, each encodes data from different CPE, using a two different carrier frequencies and different modulation schemes. Either FSK (Frequency Shift Keying), PSK (Phase Shift Keying), or ASK (Amplitude Shift Keying) modulation is applied on 1st carrier and baseband signal. The 2nd carrier and baseband signal are modulated with one of the three that is not used for the 1st carrier. To extract the two messages at the receiver side, two separate bandpass filters and demodulators are used to extract the messages simultaneously.

This implementation provides two independent data channels over two different carriers, which is ideal for the 1002 Individual Scheme. This implementation also has an advantage in term of redundancy over the first one.

Concept Implementation

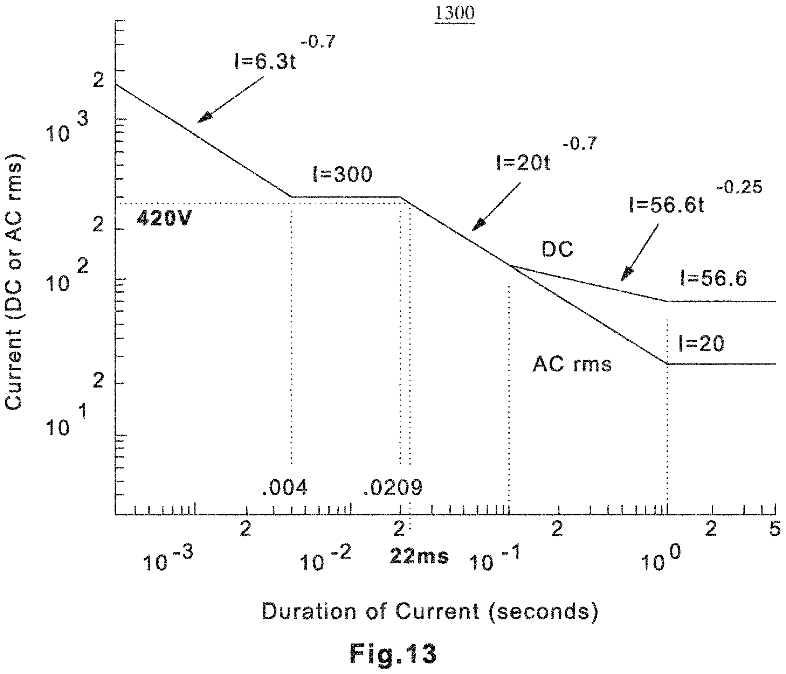

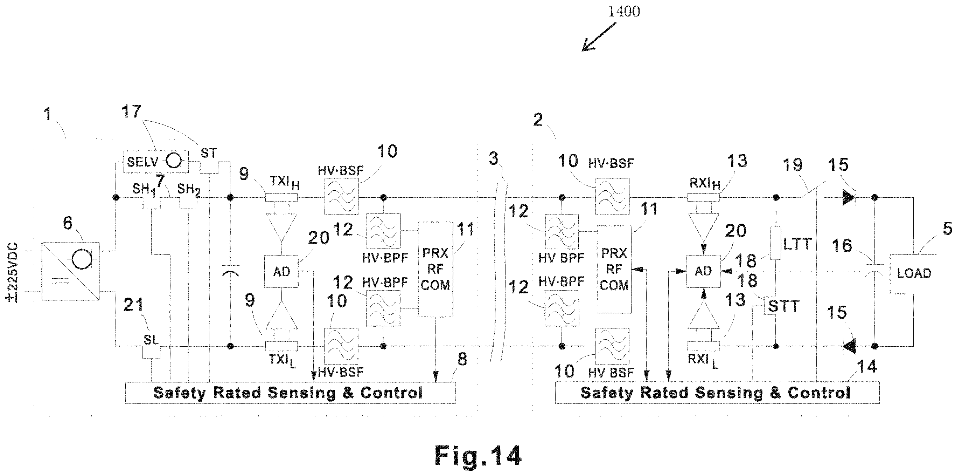

FIG. 13 illustrates a graph 1300 showing an implementation of the UL 1400-1 "Fault Current Limit Curve (mA)" for Class 4 power delivery systems according to some embodiments of the solution described herein. FIG. 14 demonstrates a high-level implementation for the concept. Setting the system's source voltage Reference (6) $\pm210V$ DC (420V DC), the fault current limit duration can be calculated as follows:

$$DC_{RMS} = \frac{420}{HBM_{Res}} \times HF = \frac{420}{575} \times 0.4 = 292mA \rightarrow D = 22ms$$

where $HBM_{Res}$ is the human body resistance defined in UL1400-1. HF is the heart factor.

D = 22 milliseconds is the allowed duration for the given parameters. That means $t_{cycle}$ 37 should be limited to $\leq 22ms$. By other words, the system should response to a fault in no more than 22ms.

The UL1400-1 calls for $2K\Omega$ $HBM_{Res}$. To design the system to be robust with sufficient margin, let's assume that the $HBM_{Res}$ is at least 21 times $\rightarrow 21K\Omega$. The fault current as a result of touch can be calculated as follows:

$$I_{Touch} = \frac{V_{Line}}{R_{Touch}} = \frac{420V}{20K\Omega} = 21mA$$

Assuming the system was designed to supply up-to 882W, which means the load current at 420V is 2100mA, we can calculate the maximum allowed current sensing error for the whole system as follows:

$$Sys_{error} = \frac{21mA}{2100mA} \times 100 = 1\%$$

If $10m\Omega$ / 0.1% tolerance / $25ppm$ precision sense resistor was used, the current sensing error per node can be calculated as follows:

$$R_{25PPM} = \frac{R}{1M} \times PPM = \frac{10m\Omega}{1M} \times \pm25 = \pm0.00025m\Omega$$

$$R_{0.1\%} = \frac{PPM}{100} \times R = \pm\frac{0.1\%}{100} \times 10m\Omega = \pm0.01m\Omega$$

$$R_{error} = \pm\frac{(0.01 + 0.00025)}{10} = \pm0.01025m\Omega$$

$$V_{Rsense\_error@21mA} = 21mA \times 0.01025m\Omega = \pm0.21525\mu V$$

$$V_{Rsense\_error@2100mA} = 2100mA \times 0.01025m\Omega = \pm21.525\mu V$$

$$V_{Rsense@21mA} = 21mA \times 10m\Omega = 210\mu V$$

$$V_{Rsense@2100mA} = 2100mA \times 10\text{m}\Omega = 21mV$$

$$Ratio = 100$$

Assuming that the measurement error is $\pm5$ of $I_{Touch} = 21mA \times 0.05 = \pm1.05mA$. Which converts into $\pm10\mu V$. To have a measurement accuracy down to $\pm10\mu V$, the ADC Effective Resolution should be calculated as follows:

$$ER = \log_2\left(\frac{V_{IN_{FSR}}}{V_{RMS\_noise}}\right) = \log_2\left(\frac{2.4V}{32 \times 10\mu V}\right) = 12.8727 \ bits$$

As a practical example: ADS 131M04, a 24-bit, delta-sigma ($\Delta\Sigma$) ADC, has a Full-Scale Range (FSR) $\pm1.2$V/Gain and ER equal 13.7 bits at a sampling rate of 64 kbps and a gain of 32.

The SDCP systems described herein provide highly reliable fault detection and management schemes for safe high-voltage DC power delivery and distribution. The implementation of these solutions meet the requirements for Class 4 power system designed to comply with UL Standard 1400 for a safer, more reliable, and easy-to-install power delivery system.

The SDCP systems described herein also employ various techniques and methods used to integrate a SIL (safety integrity level) rated RF communication link over a high-voltage single pair conductor cable.

A System Integrity Self-Check (Test-the-Tester) scheme may also be incorporated into the SDCP systems to validate the reliability and integrity of the system at the initialization stage and during normal operation.

A Load Presence function may also be incorporated into the SDCP systems to validate the presence of the load/node and the number of nodes connected to the system at the initialization stage and during normal operation.

A Transmission Line Safety Check scheme may also be incorporated into the SDCP system During Initialization; a dynamic and slotted communication link may also be incorporated into the SDCP system; two different RF communication schemes may also be incorporated into the SDCP system for redundant data communication over a single pair power conductor; and a system calibration and validation function may also be incorporated into the SDCP system.

At a system level, the SDCP systems described herein provide a fault detection and management scheme for providing safe, high-voltage, DC power delivery and distribution systems. These SDCP systems: Meets the requirements for Class 4 power systems and complies with UL Standard 1400-1 for a safer, more reliable, and easy-to-install power delivery system; Controls the high-voltage, direct current (DC) delivery from the source (transmitter), over a standard multi-conductor copper cable, to the load (receiver) without pulsing/chopping the power (Voltage and/or Current); The networking Interface of multiple systems can be daisy chained for expanding the capacity of system power delivery for a unified infrastructure management and control; Composed of three main elements: DC Power Transmitters (DC-PTX), DC Power Receivers (DC-PRX), and a power transmission lines (PTL); Each Transmitter can connect to one Receiver in point-to-point fashion or to multiple Receivers in "bus or multi-drop" topology; The receiver converts the high voltage direct current into a voltage applicable to the clients (e.g., +/-57 VDC), which can be used to power multiple end devices; The receiver supports multiple channels to be combined to support a higher output power through a power combiner circuit that integrates controlled output switches, reverse current protection controller, load sharing controller, and a sophisticated load startup algorithm; The system operates in two different modes: 1) System Initialization and Verification Mode; 2) Normal Operation Mode; Transmission Line Safety Check, Presence of DC-RTX Check, and System Integrity Self-Check are conducted during initialization, as well as during normal operation; A safety extra low voltage (SELV) source and a calibrated reference load are enabled during system initialization and/or a fault recovery to verify the presence of Reference (2), establish the RF communication link, and verify the safety condition of Reference (3) before enabling the high-voltage source; and the systems implemented redundant fault detection circuits to achieve a better Fault-in-Time rate (FIT) and/or higher Safety Integrity Level (SIL) rate.

The SDCP systems described herein further provides transmission line safe check during initialization that includes: A Safety Extra Low Voltage (SELV) source 17 (as defined in UL1400-1 a value less than the "let-go" limit) on the DC-PTX side, and a calibrated circuit component 18 (e.g., reference load) on the DC-RTX side are employed to verify the PTL is safe before enabling the high voltage power. The calibrated circuit component 18 (e.g., reference load) can be fixed or programmable load; Before enabling the high voltage power source, the SELV 17 sets the PTL voltage to an SELV value that powers up the receiver side 2 control and communication circuits; The transmitter side 1 pings the receiver side 2 to introduce the calibrated circuit component 18 (e.g., reference load) that will sink a calibrated reference current; The receiver side 2 monitors the calibrated circuit component 18 (e.g., reference load) sinking current via the current sensing circuit 13 and communicate its data to the transmitter side 1; The transmitter side 1 monitors the PTL feeding current via the current sensing circuit 9; and the transmitter side 1 compares all measurements to verify the PTL status.

The SDCP systems described herein further provides a presence of DC-RTX check that includes: a Load Presence function is incorporated into the design to validate the presence and the number of DC-RTX nodes connected to the system at the initialization stage and during normal operation; The SELV 17 together with the calibrated circuit component 18 (e.g., reference load) also provide the Presence of DC-RTX Check; During initialization, the transmitter side 1 detects the presence of DC-RTX after validating PTL 3 status by the measuring the calibrated circuit component 18 (e.g., reference load) pre-defined load value; and the transmitter side 1 also detects the presence of DC-RTX via the communication link response.

The SDCP systems described herein further provides a System Integrity Self-Check (Test-the-Tester) During Initialization that includes: Conducted before or after the PTL Status Safety Check and/or Presence of DC-RTX Check; Validates the Communication Link Quality of Service for any issues in communicating data in the defined bandwidth; Validates the system accuracy by means of SELV calibrated voltage level(s) via the SELV 17 and introducing calibrated load(s) via the calibrated circuit component 18 (e.g., reference load); and the measured data on both ends are compared together and/or to the pre-defined reference values.

The SDCP systems described herein further provides a System Integrity Self-Check (Test-the-Tester) During Normal Operation that includes: The transmitter side 1 and the receiver side 2 collaboratively preform a Test-the-Tester (TtT) procedure by executing on-the-fly system diagnostic without switching back to verification mode; A dynamically assigned communication slot in each communication cycle is utilized to introduce the calibrated circuit component 18 (e.g., reference load) for a very short time with and/or without disconnecting the load via the switch 19; When the calibrated circuit component 18 (e.g., reference load) is not introduced and the switch 19 is connected, the current sensing circuit 9 and the current sensing circuit 13 should both sense the load current only; When the calibrated circuit component 18 (e.g., reference load) is introduced and the switch is connected, the current sensing circuit 9 and the current sensing circuit 13 should both sense the current sum of the load and the calibrated circuit component 18 (e.g., reference load); When the calibrated circuit component 18 (e.g., reference load) is introduced and the switch 19 is disconnected, the current sensing circuit 9 and the current sensing circuit 13 should only sense the calibrated reference load 18 current; and the receiver side 2 communicates the data to the transmitter side 1 in the dynamically assigned communication slot for validation.

The SDCP systems described herein further provides a Fault Detection During Normal Operation that includes: The system detects fault incidents, including, but not limited to: 1) Human touching cable; 2) a short-circuited cable; 3) a cable/load disconnect; 4) an undervoltage case; 5) an overvoltage case; 6) overloading case; or 7) an arc event; Under a fault condition such as cable touch; cable short; or cable disconnect, the transmitter side 1 in collaboration with the receiver side 2 detects the change in the load current on the PTL 3 and instantly disconnects the high voltage power source 6 before switching into system verification; Fault conditions are monitored in real-time where the current sensing circuit 9 monitors the feeding current though the PTL 3 and the current sensing circuit 13 monitors the sink current by the load 5; The voltage on the PTL 3 is monitored by both the transmitter side 1 and the receiver side 2 circuitries for over-/under-voltage conditions; Current sensing circuits 9 and 13 are expanded to both sides of the bus on the transmitter side 1 and the receiver side 2 to: 1) add redundancy into the fault detection circuits and 2) detect any leakage current in the transmitter side 1 and/or the receiver side 2; The current monitoring data from the receiver side 2 is compared in real-time to the data on the transmitter side 1.

The SDCP systems described herein further provides an RF Communication Scheme that includes: A single or multi-frequency RF communication signal is super imposed onto the same transmission line to provide a means of system safety, management, control, and data reporting for a scalable and manageable power distribution system; Composed of high-voltage safety capacitors and resonance inductors, a differential, high-voltage, wide-band, resonance band-pass filter 12 is employed to provide reinforced isolation, block DC components, and provide channel selectivity; Composed of high-voltage capacitors and resonance inductors, a differential, high-voltage, narrow-band, resonance notch filter is employed to provide a high-impedance at the RF frequency and block the RF signal on the power bus; A multi-stage digital signal encoding/decoding and a RF modulator 32 and a RF demodulator 26 are employed for a redundant RF communication link; A redundancy scheme A is implemented using a single carrier frequency and two different digital modulation schemes, relying on modulating two different baseband signals, each encodes data from different CPE, using a single carrier frequency, where:

- In the 1st stage, FSK or PSK modulation scheme is used to modulate the carrier.
- In the 2nd stage, ASK modulation scheme is carried out on the modulated version of the carrier signal of the 1st stage.
- The first message data is frequency or phase modulated and the second message data is amplitude modulated.
- ASK and FSK demodulators are used to extract the messages simultaneously at the receive side.
  A redundancy scheme B is implemented using two different carrier frequencies-$f_1$ / $f_2$-and two different digital modulation schemes; relying on modulating two different baseband signals, each encodes data from different CPE, using a two different carrier frequencies and different modulation schemes, where

- FSK, PSK, or ASK modulation is applied on 1st carrier and baseband signal.
- The 2nd carrier and baseband signal are modulated with a different modulation that applied to the 1st carrier and baseband.
- Two separate selective filters and demodulators are used to extract the messages simultaneously at the receive side.

The SDCP systems described herein further provides a Multi-Drop Bus and Slotted Communication Link that includes: The multi-drop system implements single-master, multi-slave configuration topology; The communication link employs slotted communication protocol where each slave/node in the receiver side 2 utilizes a pre-defined or an assigned communication slot within a dynamic communication window to communicate its data; A communication slot 36 is assigned by the master receiver side 2 in an Asynchronized Communication Mode or pre-defined in a Synchronized Communication Mode; The time of each slot is dynamically adjusted based on the number of nodes; The communication window 37 is dynamically adjusted for maximum utilization of the communication link bandwidth depending on the number of nodes connected to the bus; In the Asynchronized Communication Mode, each node has a unique ID and assigned a communication slot by the Master. The node communicates data upon receiving an inquiry from the master; In the Synchronized Communication Mode, the master sends a broadcast signal in the first slot 41 of each cycle for all nodes to sync. Every node communicates its data on its own in a pre-defined slot; An "Idle Time" ($t_{idl}$) is employed at the beginning and at the end of the window to account for propagation delays, tolerance factors, and reduce the chance for any communication collision; and a slot 38 is allocated for TtT procedure that is executed at the end of every cycle for self-validation within the time defined by "Fault Current Limit Curve".

Accordingly, the disclosed solution(s) include a method for fault detection in an DC-FMPS (e.g., the SDCP system 100), capable of identifying a range of fault conditions including, but not necessarily limited to, human contact, arc faults, ground faults, short-circuits, connectivity faults, and voltage irregularities such as undervoltage, overvoltage, overcurrent, and unintended high-voltage on a PTL. This method may include monitoring the line voltage and current in real-time via redundant sensors at both ends (i.e., the DC Power Transmitters and Receivers), without the need to disconnect the high-voltage switches at the DC Power Transmitter (e.g., characterized by maintaining continuous DC flow in a high-voltage DC power distribution system without chopping or pulsing).

Accordingly, the disclosed solution(s) include a DC-FMPS including a safety extra low voltage (SELV) source and a calibrated reference load that are enabled during a system initialization and/or a fault recovery operational period to verify the presence of a receiver, establish an RF communication link, charge up a bulk capacitor, and verify a safety condition of a PTL before enabling the high-voltage source. Load Presence is verified via the communication link. The status of the PTL is verified by measuring the differential and common mode current and voltage on both ends of the PTL, communicating the data from the DC-PRX to the DC-PTX over the PTL, and compare the measurements to make a collaborative decision to enable the HV DC source if and only if the measurements at both ends matches. Any differences in current measurements are indicative of abnormalities on the PTL such as, but not limited to, Touch Fault adding a leakage current on the PTL or Arc Fault causing impedance in series with the PTL. Under a fault condition such as cable touch, cable short, arc fault, or cable disconnect, the DC-PTX in collaboration with the DC-PRX detects the change in the load current on the PTL and instantly disconnect the current sensing circuit 9, via one or more of the switches 7 on the DC-PTX 1 before switching into a system verification operational mode.

Accordingly, the disclosed solution(s) include a method for System Integrity Self-Check (Test-the-Tester, hereinafter may be referred to as "TtT") during an initialization and normal operation mode of a DC-FMPS. The System Integrity Self-Check is configured to validate the system accuracy by means of SELV calibrated voltage level(s) via the circuit component 17 and introducing calibrated load(s) via the circuit component 18. The measured data on both ends are compared together and/or to the pre-defined reference values. The DC-PTX and DC-PRX within the DC-FMPS collaboratively perform a TtT procedure by executing on-the-fly system diagnostic without switching back to verification mode. A dynamically assigned communication slot in each communication cycle is utilized to introduce the calibrated reference load in the circuit component 18 for a very short time with and/or without disconnecting the load via the switch 19 on the DC-PRX 2.

Accordingly, the disclosed solution(s) include a method for establishing a functional safety level communication link on a PTL composed of a single or multi-frequency RF communication signal that is super imposed onto the same transmission line to provide a means of system safety, management, and control within a DC-FMPS. The redundancy of the link is achieved by a Scheme 1: A single carrier frequency and two different digital modulation schemes, relying on modulating two different baseband signals, each encodes data from different CPE, using a single carrier frequency; or a Scheme 2: two different carrier frequencies and two different digital modulation schemes; relying on modulating two different baseband signals, each encodes data from different CPE. The communication link employs slotted communication protocol where each slave/node utilizes a pre-defined or an assigned communication slot within a dynamic communication window to communicate its data. A slot 38 is allocated for TtT procedure that is executed at the end of every cycle for self-validation within the time defined by "Fault Current Limit Curve".

The methods, devices, processing, circuitry, and logic described above may be implemented in different ways and in different combinations of hardware and software. For example, all or parts of the device implementations may be circuitry including an instruction processor, such as a Central Processing Unit (CPU), microcontroller, or a microprocessor; or as an Application Specific Integrated Circuit (ASIC), Programmable Logic Device (PLD), or Field Programmable Gate Array (FPGA); or as circuitry that includes discrete logic or other circuit components, including analog circuit components, digital circuit components or both; or any combination thereof. The circuitry may include discrete interconnected hardware components or may be combined on a single integrated circuit die, distributed among multiple integrated circuit dies, or implemented in a Multiple Chip Module (MCM) of multiple integrated circuit dies in a common package, as examples.

Accordingly, the circuitry may store or access instructions for execution, or may implement its functionality in hardware alone. The instructions may be stored in a tangible storage medium that is other than a transitory signal, such as a flash memory, a Random Access Memory (RAM), a Read Only Memory (ROM), an Erasable Programmable Read Only Memory (EPROM); or on a magnetic or optical disc, such as a Compact Disc Read Only Memory (CDROM), Hard Disk Drive (HDD), or other magnetic or optical disk; or in or on another machine-readable medium. A product, such as a computer program product, may include a storage medium and instructions stored in or on the medium, and the instructions when executed by the circuitry in a device may cause the device to implement any of the processing described above or illustrated in the drawings.

**Claims**

1. A DC power transmitter for use in a class 4 power system, the DC power transmitter comprising:

   a high voltage power supply;
   a current sensing circuit configured to monitor a current on a bus coupled to the high voltage power supply;
   a safety controller configured to monitor an output of the current sensing circuit and to control a switch to regulate a power output of the high voltage power supply;
   a communication interface configured to receive a communication signal from the safety controller;
   a band pass filter configured to receive the communication signal from the communication interface and transmit the communication signal over a transmission line; and
   a band stop filter configured to receive the power output from the high voltage power supply and transmit the power output over the transmission line.

2. The DC power transmitter of claim 1, wherein the high voltage power supply further includes a current limiter tuned to a maximum current of the DC power transmitter, and optionally wherein the output power from the high voltage power supply is configured to be up to 225V DC.

3. The DC power transmitter of any preceding claim, wherein the communication interface is a radio frequency (RF) modulator/demodulator configured to modulate and demodulate the communication signal in an RF format received from the safety controller.

4. The DC power transmitter of any preceding claim, further comprising:
   a transmitter-side circuit component configured to place a safety extra low voltage (SELV) signal on the transmission line to communicate with a receiver-side circuit component located on a receiver coupled to the transmission line to verify a safety status of the transmission line before enabling the high voltage power supply to provide the output power over the transmission line to the receiver.

5. The DC power transmitter of claim 4, wherein the SELV signal is placed on the transmission line during a system initialization state.

6. The DC power transmitter of any of claims 4-5, wherein the SELV signal is placed on the transmission line during a fault recovery state and optionally wherein the transmission line is a cable including a plurality of conductor wires having at least 18 AWG or thicker.

7. The DC power transmitter of any of claims 4-6, wherein the transmitter-side circuit component is configured to:

   transmit a ping signal to the receiver-side circuit component to introduce a calibrated reference load at the receiver that will sink a calibrated reference current;

receive a monitoring signal from the receiver-side circuit component confirming the calibrated reference current of the calibrated reference load; and
verify the safety status based on a comparison of the calibrated reference current and the current sensed on the transmission line by the current sensing circuit.

8. The DC power transmitter of any of claims 5-8, wherein the transmitter-side circuit component is configured to:
receive a response signal from the receiver-side circuit component via the transmission line, the response signal confirming a presence of the receiver by providing a measurement of a reference load on the receiver.

9. The DC power transmitter of any of claims 4-8, wherein the transmitter-side circuit component is configured to:
compare a voltage across a reference load on the DC power transmitter and a voltage across a reference load on the receiver to validate a quality of data communication across the transmission line.

10. The DC power transmitter of any of claims 4-9, wherein the transmitter-side circuit component is configured to:

superimpose an RF signal on the transmission line;
establish an RF communication link for communicating information to the receiver coupled to the transmission line;
transmit, to the receiver via the RF communication link, a first voltage detection signal identifying a voltage measured across a reference load on the DC power transmitter;
receive, at the DC power transmitter via the RF communication link, a second voltage detection signal from the receiver identifying a voltage measured across a reference load on the receiver;
compare, at the DC power transmitter, the voltage measured across the reference load on the DC power transmitter and the voltage measured across the reference load on the receiver;
receive, at the DC power transmitter via the RF communication link, a validation signal from the receiver indicating a comparison of the voltage measured across the reference load on the DC power transmitter and the voltage measured across the reference load on the receiver matched;
verify the safety status of the transmission line when the comparison at the DC power transmitter and the validation signal confirm that the voltage measured across the reference load on the DC power transmitter and the voltage measured across the reference load on the receiver match; and
enabling the high voltage power supply to provide the output power over the transmission line when the safety status is verified.

11. The DC power transmitter of any of claims 4-10, wherein the transmitter-side circuit component is configured to:

superimpose an RF signal on the transmission line;
establish an RF communication link for communicating information to the receiver coupled to the transmission line;
transmit, to the receiver via the RF communication link, a first current detection signal identifying a current measured across a reference load on the DC power transmitter;
receive, at the DC power transmitter via the RF communication link, a current voltage detection signal from the receiver identifying a current measured across a reference load on the receiver;
compare, at the DC power transmitter, the current measured across the reference load on the DC power transmitter and the current measured across the reference load on the receiver;
receive, at the DC power transmitter via the RF communication link, a validation signal from the receiver indicating a comparison of the current measured across the reference load on the DC power transmitter and the current measured across the reference load on the receiver matched;
verify the safety status of the transmission line when the comparison at the DC power transmitter and the validation signal confirm that the current measured across the reference load on the DC power transmitter and the current measured across the reference load on the receiver match; and
enabling the high voltage power supply to provide the output power over the transmission line when the safety status is verified.

12. The DC power transmitter of any of claims 4-11, wherein the transmitter-side circuit component is configured to:

superimpose an RF signal on the transmission line;
establish an RF communication link for communicating information to the receiver coupled to the transmission line;

transmit, to the receiver via the RF communication link, a first current detection signal identifying a current measured across a reference load on the DC power transmitter;

transmit, to the receiver via the RF communication link, a first voltage detection signal identifying a voltage measured across a reference load on the DC power transmitter;

receive, at the DC power transmitter via the RF communication link, a current voltage detection signal from the receiver identifying a current measured across a reference load on the receiver;

receive, at the DC power transmitter via the RF communication link, a second voltage detection signal from the receiver identifying a voltage measured across a reference load on the receiver;

compare, at the DC power transmitter, the current measured across the reference load on the DC power transmitter and the current measured across the reference load on the receiver;

compare, at the DC power transmitter, the voltage measured across the reference load on the DC power transmitter and the voltage measured across the reference load on the receiver;

receive, at the DC power transmitter via the RF communication link, a validation signal from the receiver indicating a comparison of the current measured across the reference load on the DC power transmitter and the current measured across the reference load on the receiver matched;

receive, at the DC power transmitter via the RF communication link, a validation signal from the receiver indicating a comparison of the voltage measured across the reference load on the DC power transmitter and the voltage measured across the reference load on the receiver matched;

verify the safety status of the transmission line when at least one of the comparison at the DC power transmitter and the validation signal confirm that the current measured across the reference load on the DC power transmitter and the current measured across the reference load on the receiver match, or the comparison at the DC power transmitter and the validation signal confirm that the voltage measured across the reference load on the DC power transmitter and the voltage measured across the reference load on the receiver match; and

enabling the high voltage power supply to provide the output power over the transmission line when the safety status is verified.

13. The DC power transmitter of any of claims 1-4, further comprising:

a fault detection circuit for identifying a fault condition within the class 4 power system, and optionally, wherein the fault condition includes at least one of: a touch of the transmission line, a short circuit on the transmission line, a transmission line or load disconnection, an undervoltage case, an overvoltage case, or an unwanted arc event.

14. The DC power transmitter of claim 13, wherein the fault detection circuit is configured to:

communicate with a receiver-side fault detection circuit to identify the fault condition based on a change in current on the transmission line; and

disconnect the high voltage power supply when the fault condition is identified, and optionally, wherein the communication interface is configured to:

superimpose an RF signal on the transmission line;

establish an RF communication link for communicating information to a receiver coupled to the transmission line; and

receive, via the RF communication link, from the receiver a verification message including a confirmation signal that a load is safely detected by the receiver.

15. The DC power transmitter of claim 14, wherein the RF communication link provides a redundancy by at least one of: using a single carrier frequency and two different digital modulation schemes, relying on modulating two different baseband signals, each encoding data from a different computation processing element (CPE), and using a single carrier frequency, and

using two different carrier frequencies and two different digital modulation schemes, and relying on modulating two different baseband signals, each encoding data from a different computation processing element (CPE).

100

| 1 | | 2 |

Class4
DC-PTX

3 ⎰ Class4
PTL

Class4
DC-PRX

**Fig.1**

Fig.2

**Fig.3**

EP 4 443 684 A1

Fig.4

**Fig.5**

**Fig.6**

EP 4 443 684 A1

**Fig.7**

EP 4 443 684 A1

**Fig.8**

**Fig.9**

EP 4 443 684 A1

$$t_{cycle} = \sum_{1}^{n} t_{slot(m+n)}$$

$$t_{Slot\,m+2} \leq t_{idl} + t_{qry} + t_{pcs} + t_{rsp} + t_{idl}$$

Fig.10

Fig.11

1200

PT-RF COM  11

RX BIN DATA  29

28

27

Multi-stage RF Demodulator  26

x(n-m)

A  25

24

TUNE & MATCH  23

RF CMRF  22

TX BIN DATA  30

Carrier  31

Multi-stage RF Modulator  32

Baseband

D  33

34

**Fig.12**

Fig.13

Fig.14

Europäisches
Patentamt

European
Patent Office

Office européen
des brevets

**EUROPEAN SEARCH REPORT**

Application Number

EP 24 16 7093

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TW I 671 969 B (RICHTEK TECHNOLOGY CORP [TW]) 11 September 2019 (2019-09-11) * figure 2 * ----- | 1-15 | INV. H02J1/02 H02J13/00 H04B3/54 |
| A | US 2020/235949 A1 (JONES CHAD M [US] ET AL) 23 July 2020 (2020-07-23) * figure 18a * ----- | 1-15 | |

**TECHNICAL FIELDS SEARCHED (IPC)**

H02J
H04B

The present search report has been drawn up for all claims

| Place of search | Date of completion of the search | Examiner |
|---|---|---|
| Munich | 31 July 2024 | Bourdon, Jérémy |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
...........................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 16 7093

This annex lists the patent family members relating to the patent documents cited in the above-mentioned European search report.
The members are as contained in the European Patent Office EDP file on
The European Patent Office is in no way liable for these particulars which are merely given for the purpose of information.

31-07-2024

| Patent document cited in search report | | Publication date | Patent family member(s) | | Publication date |
|---|---|---|---|---|---|
| TW  I671969 | B | 11-09-2019 | TW | 201916515 A | 16-04-2019 |
| | | | US | 2018286609 A1 | 04-10-2018 |
| US 2020235949 | A1 | 23-07-2020 | CA | 3125024 A1 | 30-07-2020 |
| | | | CN | 113330718 A | 31-08-2021 |
| | | | EP | 3915229 A1 | 01-12-2021 |
| | | | US | 2020235949 A1 | 23-07-2020 |
| | | | US | 2020389329 A1 | 10-12-2020 |
| | | | US | 2022385334 A1 | 01-12-2022 |
| | | | US | 2024113903 A1 | 04-04-2024 |
| | | | WO | 2020154103 A1 | 30-07-2020 |

EPO FORM P0459

For more details about this annex : see Official Journal of the European Patent Office, No. 12/82

**REFERENCES CITED IN THE DESCRIPTION**

**Patent documents cited in the description**

- US 63457191